# EUROPEAN PATENT APPLICATION

(11) **EP 0 619 523 A2**
(43) Date of publication of application: **12.10.1994**
(21) Application number: 94105332.4
(22) Date of filing: 06.04.1994
(51) Int. Cl.: G03F 7/07

(54) **Method for preparing lithographic printing plate**

(30) Priority: 06.04.1993 JP 79324/93
(71) Applicant: FUJI PHOTO FILM CO., LTD., Kanagawa (JP)
(72) Inventor: Hirano, Masato, c/o Fuji Photo Film Co., Ltd., Minami-Ashigara-shi, Kanagawa (JP); Kojima, Tetsuro, c/o Fuji Photo Film Co., Ltd., Minami-Ashigara-shi, Kanagawa (JP)
(74) Representative: Grünecker, Kinkeldey, Stockmair & Schwanhäusser Anwaltssozietät

(57) **Abstract**

A lithographic printing plate is prepared from a silver halide photosensitive material in accordance with a DTR process. The photosensitive material is exposed and developed with a diffusion transfer processing solution containing a compound of the formula: RSO₂SM wherein R is an aliphatic, aromatic or heterocyclic group and M is a hydrogen atom or cation as a silver halide complexing agent. The printing plate has good ink receptivity and minimized plate wear. The processing solution is free from the problems of corrosion and waste solution disposal.

## Description

### BACKGROUND OF THE INVENTION

### Field of the Invention

This invention relates to a method for preparing a lithographic or planographic printing plate in accordance with a silver complex diffusion transfer process, and a processing solution used therefor.

### Prior Art

Printing plates designed such that a silver image obtained by the silver complex diffusion transfer reversal (DTR) process is used as an offset printing master are known in the art as disclosed in Land et al., USP 3,220,837, De Haes et al., USP 3,721,559, Japanese Patent Publication (JP-B) Nos. 43132/1971, 16725/1973, and 30562/1973, and Japanese Patent Application Kokai (JP-A) No. 004482/1971 and 021603/1978. Among them, some printing plates are used in practice.

In general, a lithographic printing plate has a printing surface including a lipophilic image area capable of receiving greasy ink and a hydrophilic non-image area repellent to ink and is a hydrophilic area receptive to water. Lithographic printing is usually carried out by supplying water and ink simultaneously to the plate surface so that the image area receives coloring ink and the non-image area receives water both preferentially whereupon the ink on the image area is transferred to an ink-receptive sheet, typically paper. Printed matter is obtained in this way. The key to satisfactory printed matter is a definite difference between cage and non-image areas, that is, a definite difference between lipophilic and hydrophilic properties. It is necessary that when water and ink are supplied to the plate surface, the image area receive a sufficient amount of ink and the non-image or background area do not receive ink at all.

One of the drawbacks of lithographic printing plates prepared by the silver complex diffusion transfer reversal (DTR) process is that they are less resistant to mechanical wear so that hydrophobic areas carrying ink images gradually lose ink receptivity. That is, printing endurance (also known as plate wear or run length) is reduced. In turn, hydrophilic areas gradually become hydrophobic, that is, non-image areas or background areas are contaminated with ink. Further, hydrophobic image areas become defective in uniform greasy ink receptivity. A variation in ink receptivity occurs among the image areas, meaning that the areas to be printed do not receive a uniform quantity of ink.

Important factors dictating that silver grains transfer-developed by the DTR process endure more printing operation are the conditions under which transferred silver grains are generated, for example, the diffusion rate, stability and reduction rate of a silver complex salt as well as the size and shape of the thus developed silver grains although these conditions somewhat depend on the components of the lithographic printing plate.

A number of silver halide complexing agents are known for use in the development step of diffusion transfer process. Examples include (1) thiosulfate salts, (2) thiocyanate salts, (3) aminothiosulfates as disclosed in US Patent 3,169,992, (4) cyclic imide compounds as disclosed in US Patent 2,857,276, (5) 2-mercaptobenzoic acids as disclosed in JP-B 4099/1986, and (6) thiosalicylic acids and cyclic imide compounds having a five or six-membered ring as disclosed in JP-B 4100/1986. Printing plates which are prepared through development with such silver halide complexing agents have the advantages of high sensitivity, high resolution, and high image reproducibility, but are prone to plate wear as compared with other practical printing plates such as presensitized plates. It is thus desired to improve the printing endurance of such plating plates.

Among the above-mentioned silver halide complexing agents, the thiocyanates are most preferred in view of the printing endurance of transfer-developed silver grains and economy. The use of thiocyanates, however, has several problems including (1) corrosion in that thiocyanates are metal corrosive and thus tend to attack parts of the processing equipment, (2) restricted solution disposal in that thiocyanate solution is classified as cyan-containing solution according to the waste water regulation and must be deliberately treated before discarding to the environment, (3) cumbersomeness in that thiocyanates are deliquescent so that their handling is difficult and their processing solution requires care during preparation, and (4) careful management of processing solution in that ink-receptivity largely depends on the amount of thiocyanate added.

### SUMMARY OF THE INVENTION

A primary object of the present invention is to provide an improved method for preparing a lithographic printing plate featuring high ink-receptivity, little or no scumming, and outstandingly reduced printing endurance.

Another object of the present invention is to provide an improved diffusion transfer processing solution which has eliminated the corrosion and solution disposal problems and is easy to handle and manage.

In a first form, the present invention is directed to a method for preparing a lithographic printing plate from a photosensitive material comprising at least a silver halide emulsion layer and a physical development nucleus layer on a support in accordance with a silver complex diffusion transfer process. The photosensitive material is processed with a diffusion transfer processing solution which contains at least one compound of the general formula (I):

RSO₂SM (I)

wherein R is an aliphatic, aromatic or heterocyclic group, and M is a hydrogen atom or a cation.

A diffusion transfer processing solution containing at least one compound of formula (I) for use in the preparation of a lithographic printing plate is also contemplated.

### DETAILED DESCRIPTION OF THE INVENTION

According to the present invention, a lithographic or planographic printing plate is prepared by processing a photo-sensitive material with a processing solution in accordance with the silver complex diffusion transfer process for forming a silver image. The photosensitive material includes at least a silver halide emulsion layer and a physical development nucleus layer on a support. The diffusion transfer processing solution contains a silver halide complexing agent in the form of a compound of the general formula (I).

RSO₂SM (I)

In formula (I), R is an aliphatic, aromatic or heterocyclic group. The aliphatic group represented by R is preferably selected from aliphatic groups having 1 to 30 carbon atoms, especially linear, branched or cyclic alkyl, alkenyl, alkynyl, and aralkyl groups having 1 to 20 carbon atoms. Exemplary are methyl, ethyl, isopropyl, t-butyl, n-octyl, n-decyl, n-hexadecyl, cyclopropyl, cyclopentyl, cyclohexyl, allyl, 2-butenyl, 3-pentenyl, propargyl, 3-pentynyl, and benzyl groups.

The aromatic group represented by R is preferably selected from aromatic groups having 6 to 30 carbon atoms, especially monocyclic or fused ring aryl groups having 6 to 20 carbon atoms, for example, phenyl and naphthyl groups.

The heterocyclic group represented by R is preferably selected from 3- to 10-membered, saturated or unsaturated, heterocyclic groups containing at least one atom of nitrogen, oxygen and sulfur atoms. They may be monocyclic or form a fused ring with another aromatic ring. Preferred are 5- or 6-membered aromatic heterocyclic groups, for example, pyridyl, imidazolyl, quinolyl, benzimidazolyl, pyrimidyl, pyrazolyl, isoquinolyl, thiazolyl, thienyl, furyl, and benzothiazolyl groups.

These groups represented by R may have a substituent. Exemplary substituents include halogen atoms such as fluorine, chlorine and bromine atoms; alkyl groups such as methyl, ethyl, n-propyl, isopropyl, t-butyl, n-octyl, cyclopentyl, and cyclohexyl groups; alkenyl groups such as allyl, 2-butenyl, and 3-pentenyl groups; alkynyl groups such as propargyl and 3-pentynyl groups; aralkyl groups such as benzyl and phenethyl groups; aryl groups such as phenyl, naphthyl, and 4-methylphenyl groups; heterocyclic groups such as pyridyl, furyl, imidazolyl, pyperidyl, and morpholino groups; alkoxy groups such as methoxy, ethoxy, and butoxy groups; aryloxy groups such as phenoxy and 2-naphthyloxy groups; amino groups such as unsubstituted amino, dimethylamino, ethylamino, and anilino groups; acylamino groups such as acetylamino and benzoylamino groups; ureido groups such as unsubstituted ureido, N-methylureido, and N-phenylureido groups; urethane groups such as methoxycarbonylamino and phenoxycarbonylamino groups; sulfonylamino groups such as methylsulfonylamino and phenylsulfonylamino groups; sulfamoyl groups such as unsubstituted sulfamoyl, N,N-dimethylsulfamoyl, and N-phenylsulfamoyl groups; carbamoyl groups such as unsubstituted carbamoyl, N,N-diethylcarbamoyl, and N-phenylcarbamoyl groups; sulfonyl groups such as mesyl and tosyl groups; sulfinyl groups such as methylsulfinyl and phenylsulfinyl groups; alkyloxycarbonyl groups such as methoxycarbonyl and ethoxycarbonyl groups; aryloxycarbonyl groups such as phenoxycarbonyl groups; acyl groups such as acetyl, benzoyl, formyl, and pivaloyl groups; acyloxy groups such as acetoxy and benzoyloxy groups; phosphoric acid amide groups such as N,N-diethylphophoric acid amide groups; alkylthio groups such as methylthio and ethylthio groups; arylthio groups such as phenylthio groups; cyano groups; sulfo groups; carboxyl groups; hydroxyl groups; mercapto groups; phosphono groups; nitro groups; sulfino groups; ammonio groups such as trimethylammonio groups; phosphonio groups; and hydrazino groups. These substituent groups may further have a substituent. Where more than one substituent is present, they may be identical or different.

In formula (I), M is a hydrogen atom or a cation. Examples of the cation include alkali metal ions such as sodium ion, potassium ion, lithium ion, and cesium ion; alkaline earth metal ions such as calcium ion and magnesium ion; ammonium groups such as unsubstituted ammonium, methylammonium, trimethylammonium, tetramethylammonium, and dimethylbenzylamonium groups; and guanidinium groups.

Preferred are those compounds of formula (I) wherein R is an aliphatic or heterocyclic group and M is a hydrogen atom, alkali metal ion or ammonium group. More preferred are those compounds of formula (I) wherein R is an aliphatic group having 1 to 6 carbon atoms and M is a sodium ion, potassium ion or unsubstituted ammonium group. Most preferred are those compounds of formula (I) wherein R is an alkyl group having 1 to 6 carbon atoms and M is a sodium ion, potassium ion or unsubstituted ammonium group. The compound of formula (I) may take the form of an inner salt between R and M.

Illustrative, non-limiting, examples of the compound of formula (I) are given below as Compound Nos. 1 to 44. 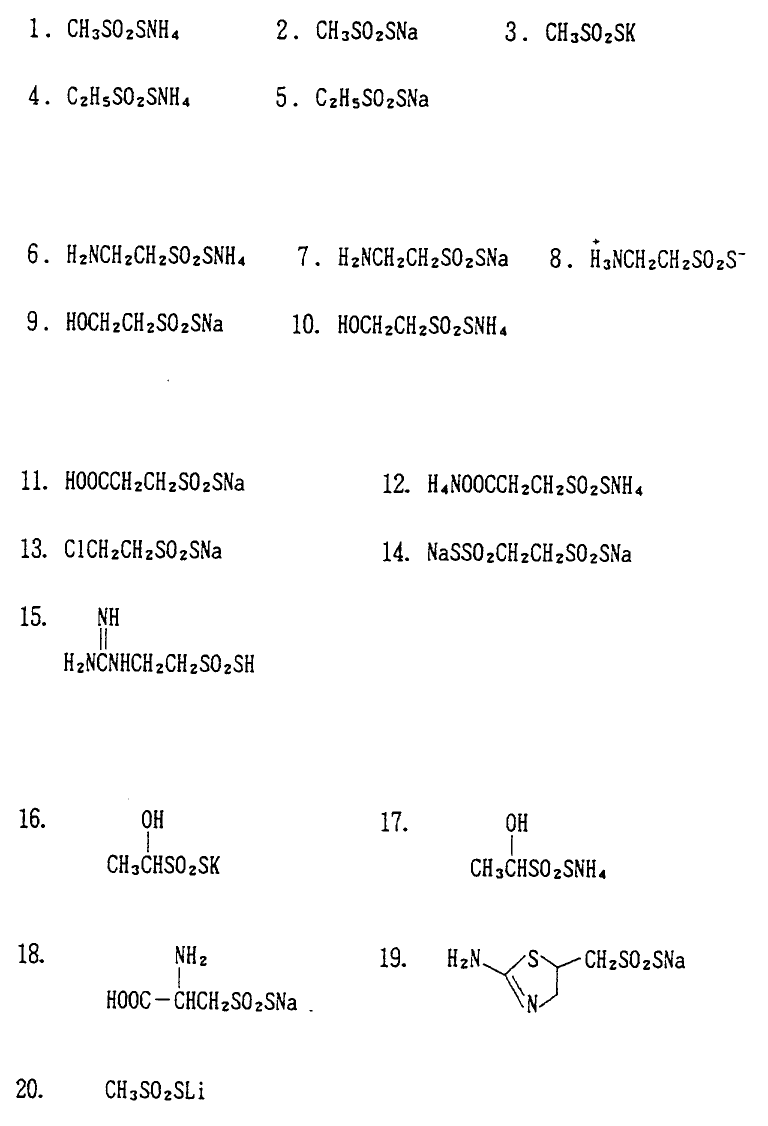 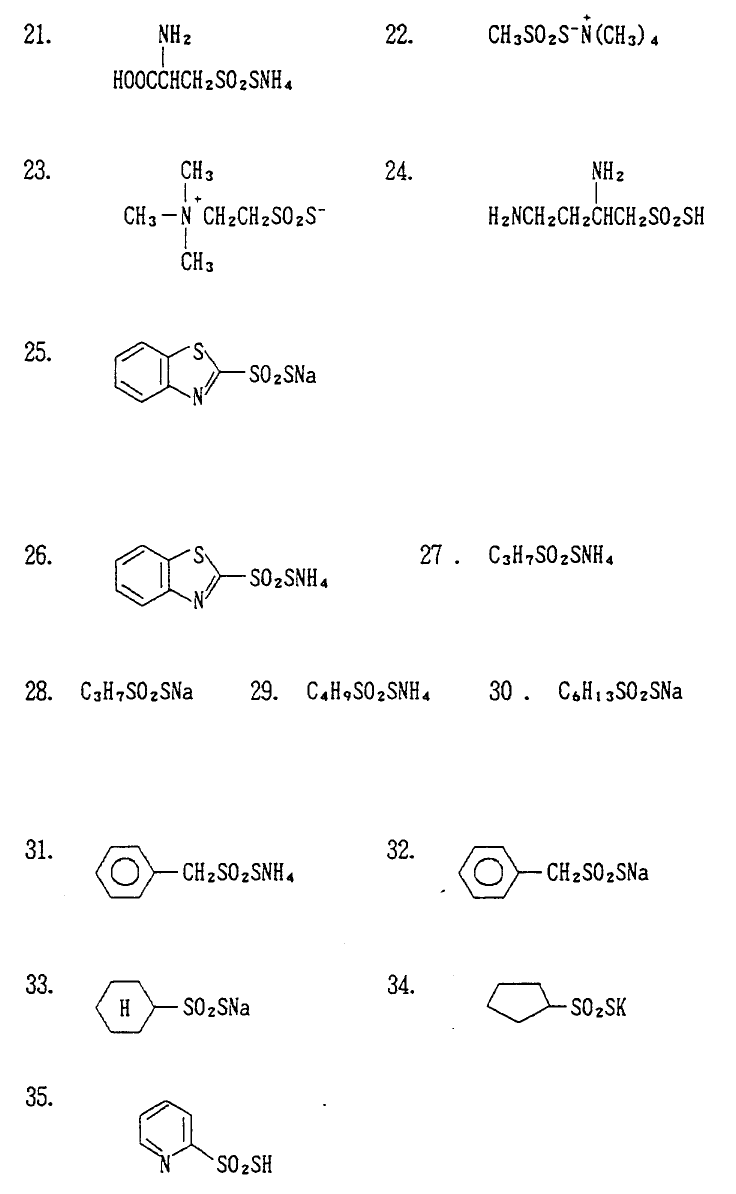 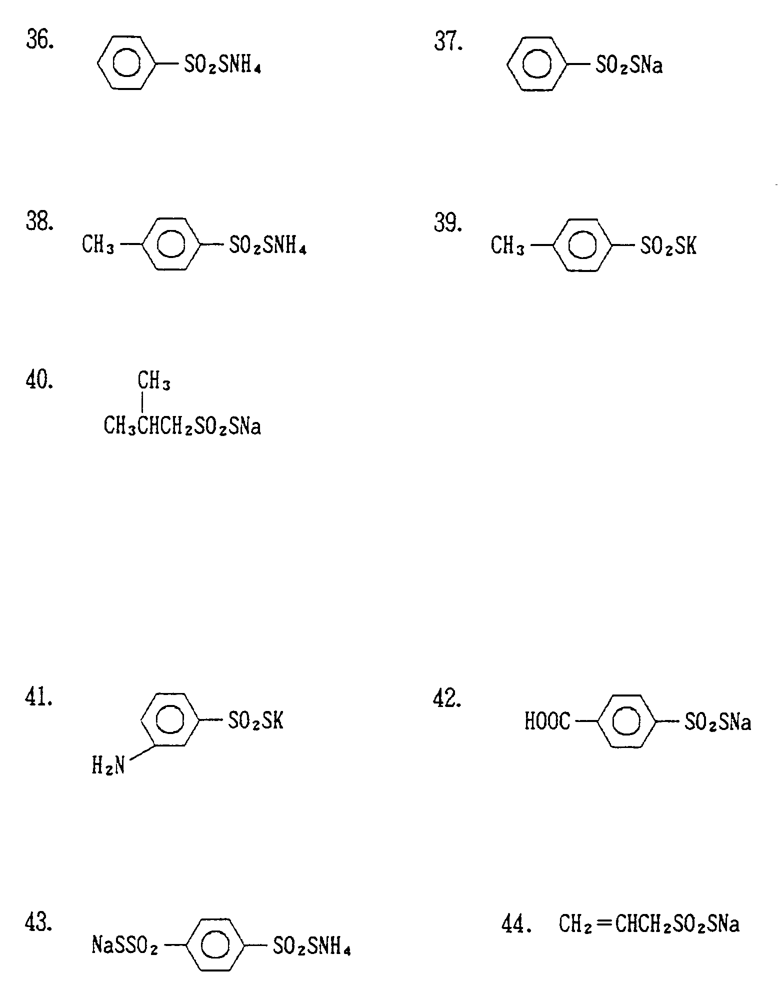
The compounds of formula (I) are well known in the art and can be synthesized by reacting sulfonyl chlorides with sulfides such as alkali metal sulfides and ammonium sulfide or by reacting sulfinic acids with elemental sulfur. For their synthesis, reference is made to, for example, Journal of Analytical Chemistry USSR, Vol. 20, 1701 (1950) and German Patent No. 840,693 (1952).

Either a single compound or a mixture of compounds of formula (I) may be used. The (total) amount of the compound(s) of formula (I) used is preferably about 0.1 to about 100 grams per liter, more preferably about 1 to about 50 grams per liter of the processing solution.

In addition to the compound of formula (I), another silver halide complexing agent may be used in the processing solution insofar as the benefits of the invention are not lost. Examples of the other silver halide complexing agent which can be used herein include thiosulfates such as sodium thiosulfate, thiocyanates such as potassium thiocyanate, aminothiosulfates as disclosed in US Patent 3,169,992, cyclic imide compounds as disclosed in US Patent 2,857,276, 2-mercaptobenzoic acids as disclosed in JP-B 4099/1986, thiosalicylic acids and cyclic imide compounds having a five- and six-membered ring as disclosed in JP-B 4100/1986.

The diffusion transfer processing solution used herein is an alkaline processing solution which is prepared by adding a compound of formula (I) to a composition essentially comprising an alkali buffer agent and a sulfite salt. Exemplary alkali buffer agents are sodium hydroxide, potassium hydroxide, sodium tertiary phosphate, and sodium carbonate, and the sulfite is typically sodium sulfite. The alkaline processing solution is generally used at pH 10 or higher, desirably pH 12 or higher.

In the practice of the invention, a developing agent may be contained in either the alkaline processing solution or the printing material. The developing agent used herein preferably includes a dihydroxybenzene, more preferably a dihydroxybenzene combined with a 1-phenyl-3-pyrazolidone or a dihydroxybenzene combined with a p-aminophenol from the standpoint of developing ability. Preferred examples of the dihydroxybenzene developing agent are hydroquinone and chlorohydroquinone, with the hydroquinone being most preferred. Preferred examples of the 1-phenyl-3-pyrazolidone developing agent are 1-phenyl-3-pyrazolidone, 1-phenyl-4,4-dimethyl-3-pyrazolidone, and 1-phenyl-4-methyl-4-hydroxymethyl-3-pyrazolidone. Preferred examples of the p-aminophenol developing agent are N-methyl-p-aminophenol, p-aminophenol, and N-(β-hydroxyethyl)-p-aminophenol, with the N-methyl-p-aminophenol being most preferred.

In addition to the above ingredients, the alkaline processing solution may further contain a thickener such as hydroxyethyl cellulose and carboxymethyl cellulose; an antifoggant such as potassium bromide; polyoxyalkylene compounds; and onium compounds.

The photosensitive material which is processed into a lithographic printing plate in accordance with the present invention includes a silver halide emulsion. The silver halide includes silver chloride, silver bromide, silver chlorobromide, and these silver halides mixed with silver iodide, preferably silver halide containing more than about 50 mol% of silver chloride. No particular limit is imposed on the size, crystal habit and distribution of silver halide grains. The silver halide emulsion may be prepared by any of conventional techniques well known in the photographic art. The silver halide emulsion may be sensitized by any of well-known chemical sensitizing techniques and spectrally sensitized in blue, green and red spectra.

The silver halide emulsion may further contain commonly used additives, for example, antifoggants, stabilizers, developing agents, gelatin hardeners, and matte agents. The silver halide emulsion further contains a binder, preferably gelatin. Part or all of gelatin may be replaced by any of natural and synthetic hydrophilic colloids, for example, albumin, casein, polyvinyl alcohol, sodium alginate, and sodium salt of carboxymethyl cellulose. The weight ratio of the hydrophilic colloid to the silver halide is generally from about 5 to about 0.3, preferably from about 2 to about 0.5, provided that the amount of silver halide is expressed by that of silver nitrate. The silver halide is coated on the support in a coverage of about 0.2 to about 5 g/m², preferably about 0.5 to about 3 g/m² calculated as silver nitrate.

An undercoat layer may be disposed below the silver halide emulsion or nearer to the support for anti-halation purposes. The undercoat layer may contain pigments such as carbon black or dyestuffs for preventing halation as well as developing agents or developing aids.

The support which is coated with the silver halide emulsion is any of conventional supports including paper, glass, various types of film (for example, cellulose acetate films, polyvinyl acetal films, polystyrene films, polypropylene films, polyethylene terephthalate films, and composite films of polyester, polypropylene or polystyrene films coated with polyethylene films), metals, metallized paper, and metal/paper laminates. Also useful are paper supports coated on one or both surfaces with an alpha-olefin polymer such as polyethylene. It is acceptable to incorporate an anti-halation pigment or dyestuff into the support.

If desired, a water-permeable binder may be thinly applied on the silver halide emulsion-bearing surface of the support as an uppermost layer. Exemplary water-permeable binders include methyl cellulose, sodium salt of carboxymethyl cellulose, hydroxyethyl cellulose, hydroxyethyl starch, sodium alginate, polyvinyl alcohol, and polyvinyl pyrrolidone.

In one common practice of the silver complex diffusion transfer process, a developing agent is incorporated in a silver halide emulsion layer and/or an image-receiving layer or another water-permeable layer adjacent thereto as disclosed in UK Patent Nos. 1,000,115, 1,012,476, 1,017,273, and 1,042,477. For this type of photosensitive material, the processing solution used in the developing step may be an "alkaline activator solution" free of a developing agent.

Preferably the physical development nucleus layer or image-receiving layer is disposed adjacent the silver halide emulsion layer. More particularly, the image-receiving layer may be disposed either above or below the silver halide emulsion layer, preferably above the silver halide emulsion layer, that is, on the side of the silver halide emulsion layer remote from the support. Physical development nuclei are provided by well-known chemical compounds, for example, metals such as antimony, bismuth, cadmium, cobalt, palladium, nickel, silver, lead and zinc and sulfides of such metals. The image-receiving layer may or may not contain a hydrophilic colloid. Exemplary hydrophilic colloids include gelatin, carboxymethyl cellulose, gum arabic, sodium alginate, hydroxyethyl starch, dextrin, hydroxyethyl cellulose, polystyrene sulfonic acid, vinyl imidazole/acrylamide copolymers, and polyvinyl alcohol.

In the image-receiving layer, there may be contained hygroscopic substances, for example, humectants such as sorbitol and glycerol. Also in the image-receiving layer, there may be contained anti-scumming pigments such as barium sulfate, titanium dioxide, china clay and silver, developing agents such as hydroquinone, and hardeners such as formaldehyde.

A lithographic printing plate is generally prepared from a photosensitive material by imagewise exposing the photo-sensitive material, developing it with the above-defined diffusion transfer processing solution, and thereafter, processing it with a neutralizing or stabilizing solution. Normally development is carried out at about 20 to 40°C for about 5 to 60 seconds and neutralization at about 20 to 40°C for about 5 to 60 seconds.

The lithographic printing plate prepared according to the present invention may be treated with compounds as disclosed in JP-B 29723/1973 and USP 3,721,559 for converting or enhancing it to be ink receptive.

The printing method using the plate, including a desensitizing solution and a fountain solution used therein, is in accord with a conventional well-known technique.

### EXAMPLE

Examples of the present invention are given below by way of illustration and not by way of limitation.

### Example 1

A double side polyethylene-coated paper support of 135 g/m² was coated on one side with a matte layer containing silica particles with a mean particle size of 5 µm. The support on the other side was treated with a corona discharge, coated with an anti-halation layer containing carbon black, and thereon with an orthochromatically sensitized high-sensitivity silver chloride emulsion containing silica particles with a mean particle size of 5 µm to a coverage of 1.5 g/m² of silver nitrate. Both the anti-halation and emulsion layers contained formaldehyde as a hardener. The support was dried and then heated at 40°C for 3 days.

A palladium sulfide sol was prepared from solutions A, B, and C. With stirring, solution A was added to solution B. After 30 minutes of mixing, the solution was purified by passing through a column charged with an ion exchange resin intended for water purification. Then solution C was added to the solution, obtaining a coating sol (adjusted to pH 4). The palladium sulfide sol was coated onto the emulsion layer at a rate of 5 m/min.

| Solution A | |
|---|---|
| Palladium chloride | 5 g |
| Conc. hydrochloric acid | 40 ml |
| Water | 1 liter |

| Solution B | |
|---|---|
| Sodium sulfide | 8.6 g |
| Water | 1 liter |

| Solution C | |
|---|---|
| Methyl vinyl ether/maleic anhydride copolymer (1.25%) | 100 ml |
| 10% saponin in water | 200 ml |
| Water | 18 liters |

The thus prepared photosensitive material, which was an origin of a lithographic printing plate, was exposed imagewise by means of a letterpress camera having an image inversion mechanism and then developed with a silver complex diffusion transfer processing solution of the following composition at 30°C for 20 seconds.

| Transfer developing solution | |
|---|---|
| Water | 750 ml |
| Sodium hydroxide | 15 g |
| Anhydrous sodium sulfite | 50 g |
| Hydroquinone | 10 g |
| 1-phenyl-3-pyrazolidone | 1 g |
| Additive* | (Table 1) |
| Water | totaling to 1 liter |

The type and amount of the additive (*) in the transfer developing solution was changed as shown in Table 1.

After development, the material was treated with a neutralizing solution of the following composition at 25°C for 20 seconds.

| Neutralizing solution | |
|---|---|
| Ethylene glycol | 5 g |
| Colloidal silica (20% aqueous solution) | 1 g |
| Na₂S₂O₃ | 4 g |
| NaH₂PO₄ | 60 g |
| Na₂HPO₄ | 10 g |
| Water | totaling to 1 liter |

In this way, there were obtained printing plates which are designated Plates 1-1 to 1-5.

Each of the printing plates was mounted in an offset press A. B. Dick 350CD (trade mark, by A. B. Dick Company). An etching solution of the following composition was thoroughly spread over the plate.

| Etching solution | |
|---|---|
| Water | 600 ml |
| Isopropanol | 50 g |
| 3-mercapto-4-acetamido-5-n-butyl-1,2,4-triazole | 1 g |

The machine was operated for printing while dampening the plate with a 10-fold diluted fountain solution of the following composition:

| Fountain solution (mother) | |
|---|---|
| Water | 880 ml |
| Succinic acid | 6 g |
| Boric acid | 8.4 g |
| Sodium sulfate | 25 g |
| Ethylene glycol | 100 g |
| Colloidal silica (20% aqueous solution) | 28 g |

The plates were evaluated for ink receptivity and printing endurance by the following procedures.

### Ink receptivity

The ink used was A. B. Dick Offset Ink 3-1012. Paper feed was started at the same time as an inking roller was contacted against the plate. The number of paper sheets fed until an acceptable image density was reached was counted. "None" means that the plate did not receive ink at all.

### Printing endurance

Printing was continued over 1,000 sheets. The number of acceptably printed paper sheets was counted until ink skips were detected in the image.

The results are shown in Table 1.

**Table 1**

| Printing plate | Additive (g) | Ink receptivity | Printing endurance |
|---|---|---|---|
| 1-1* | - | None | - |
| 1-2* | Potassium thiocyanate (20) | 50 | 500 |
| 1-3 | Compound No. 1 (26) | 17 | >5000 |
| 1-4 | Compound No. 2 (28) | 20 | ∼5000 |
| 1-5 | Compound No. 1 (13) + Compound No. 7 (17) | 18 | >5000 |

| | | | |
|---|---|---|---|
| * comparison Plate 1-2 had the problems that (1) metal members of processing equipment were corroded and (2) disposal of the used solution was under restriction. | | | |

As seen from Table 1, those printing plates which had been developed with developers containing compounds of formula (I), that is, Plates 1-3, 1-4 and 1-5, exhibited good ink receptivity and were extremely improved in plate wear as compared with the comparative ones. The inventive plates were free from the corrosion and waste solution disposal problems as would occur with thiocyanates.

### Example 2

A double side polyethylene-coated paper support of 135 g/m² was coated on one side with a matte layer containing silica particles with a mean particle size of 5 µm. The support on the other side was treated with a corona discharge, coated with an anti-halation layer containing 2 g/m² of hydroquinone, 0.1 g/m² of 1-phenyl-4-methyl-4-hydroxymethyl-3-pyrazolidone and carbon black, and thereon with a silver chloride emulsion of the same composition as in Example 1 except for panchromatic sensitization. A palladium sulfide sol (Example 1) was coated onto the emulsion layer, obtaining a photosensitive material which was an origin of a lithographic printing plate.

The photosensitive material was exposed by means of a helium neon laser image setter and then developed with an alkaline processing solution of the following composition at 30°C for 30 seconds.

| Alkaline processing solution | |
|---|---|
| Sodium hydroxide | 20 g |
| Anhydrous sodium sulfite | 50 g |
| Additive* | (Table 2) |
| Water | totaling to 1 liter |

The additive (*) or silver halide complexing agent in the alkaline processing solution was changed as shown in Table 2. After development, the material was neutralized with a neutralizing solution as in Example 1.

In this way, there were obtained printing plates which are designated Plates 2-1 to 2-4. They were evaluated by printing as in Example 1. The results are shown in Table 2.

**Table 2**

| Printing plate | Additive (g) | Ink receptivity | Printing endurance |
|---|---|---|---|
| 2-1* | - | None | - |
| 2-2* | Potassium thiocyanate (35) | 60 | 600 |
| 2-3 | Compound No. 1 (46) | 15 | >5000 |
| 2-4 | Compound No. 2 (49) | 18 | >5000 |

| | | | |
|---|---|---|---|
| * comparison Plate 2-2 had the problems that (1) metal members of processing equipment were corroded and (2) disposal of the used solution was under restriction. | | | |

As seen from Table 2, those printing plates which had been developed with developers containing compounds of formula (I), that is, Plates 2-3 and 2-4, exhibited good ink receptivity and were extremely improved in plate wear as compared with the comparative ones. The inventive plates were free from the problems associated with thiocyanates.

According to the present invention, lithographic printing plates having good ink receptivity and printing endurance are obtained. The processing solution is easy to handle since it eliminates the problems of corrosion of processing equipment and waste solution disposal.

Although some preferred embodiments have been described, many modifications and variations may be made thereto in the light of the above teachings. It is therefore to be understood that within the scope of the appended claims, the invention may be practiced otherwise than as specifically described.

## Claims

1. A method for preparing a lithographic printing plate comprising the step of processing a photosensitive material having at least a silver halide emulsion layer and a physical development nucleus layer on a support with a diffusion transfer processing solution in accordance with a silver complex diffusion transfer process,
said processing solution containing at least one compound of the following general formula:
RSO₂SM (I)
wherein R is an aliphatic, aromatic or heterocyclic group, and M is a hydrogen atom or a cation.

2. A diffusion transfer processing solution for use in a lithographic printing plate preparing method as set forth in claim 1, said processing solution containing at least one compound of formula (I).
